# EUROPEAN PATENT APPLICATION

(11) **EP 1 313 210 A1**
(43) Date of publication of application: **21.05.2003**
(21) Application number: 01204355.0
(22) Date of filing: 14.11.2001
(51) Int. Cl.: H03B 19/10, H03B 27/00, H03D 7/16, H03D 3/00

(54) **Quadrature frequency multiplier**

(71) Applicant: Semiconductor Ideas to The Market BV, 4839 AH Breda (NL)
(72) Inventor: Kasperkovitz, Wolfdietrich Georg, 5581 HA Waalre (NL)
(74) Representative: Van Straaten, Joop

(57) **Abstract**

Quadrature frequency multiplier comprising a frequency doubler included in a quadrature signal path, said frequency doubler receiving a quadrature input signal and providing a quadrature output signal of a frequency, which is double that of said input signal.
An array of such frequency doublers allow to derive from an input quadrature signal of a frequency fin, quadrature signals at frequencies mutually differing by a multiplication factor of 2ⁿ. To derive quadrature signals at a frequency in between, the invention makes use of a quadrature image frequency cancelling mixer stage having first and second quadrature inputs coupled to said quadrature signal path across said frequency doubler and providing a quadrature signal at a quadrature output having a frequency corresponding to the sum or difference of the frequencies of the signals at said first and second quadrature inputs and differing from the frequencies of the signals occurring in said quadrature signal path.

## Description

The invention relates to a quadrature frequency multiplier comprising a frequency doubler included in a quadrature signal path, said frequency doubler receiving a quadrature input signal and providing a quadrature output signal of a frequency, which is double that of said input signal. Such frequency multiplier is on itself known, e.g. from US patent number 5,389,886. The invention also relates to a receiver comprising an RF tuning stage including a tuning oscillator being coupled to a mixer stage for providing frequency conversion of an RF input signal comprising such quadrature frequency multiplier.

The known frequency multiplier may comprise one single quadrature frequency doubler or an array of x cascaded quadrature frequency doublers to provide frequency multiplication of a pair of phase quadrature signals, hereinafter also being referred to as quadrature signal, having an input frequency fin with a factor of 2ⁱ, with i varying between 1 and x. Such array can be used to derive from a single quadrature oscillator signal two or more pairs of quadature carrier signals simultaneously, differing from each other in frequency by said multiplication factor, i.e. at frequencies 2*fin, 4*fin, 8*fin...... 2^{x}*fin. This, however, hampers the known frequency multiplier from being widely used in areas such as the radio field, in which often equidistant carriers are utilised.

An object of the invention is to provide a quadrature frequency multiplier providing frequency multiplication of an input signal frequency of e.g. fin with a factor n, n being a natural integer.

It is a further object of the invention to shift and extend the frequency range of a tuning oscillator.

It is yet a further object of the invention to provide a plurality of pairs of quadature signals with equidistant frequencies simultaneously.

Another object of the invention is to provide a quadrature frequency multiplier, allowing for accurate and robust implementation..

A quadrature frequency multiplier of the type as described in the opening paragraph according to the invention is therefore characterised by a quadrature image frequency cancelling mixer stage, having first and second quadrature inputs coupled to said quadrature signal path across said frequency doubler and providing a quadrature signal at a quadrature output having a frequency corresponding to the sum or difference of the frequencies of the signals at said first and second quadrature inputs and differing from the frequencies of the signals occurring in said quadrature signal path.

With respect to the above known quadrature frequency multiplier providing quadrature signals at frequencies 2ⁱ*fin with i varying between 1 and x, the invention allows to derive from any arbitrary pair of said 2ⁱ*fin quadrature signals, a quadrature signal having a frequency at either the sum or the difference value of the frequencies of said arbitrary pair of quadrature signals. This is obtained according to the invention by the use of one or more quadrature image frequency cancelling mixer stages. An image frequency cancelling mixer circuit is on itself known from US patent nr. 5,140,198. The mixers of such image frequency cancelling mixer stage provide quadrature signals at both sum or difference frequencies of the signals at their first and second quadrature inputs. Preferably a quadrature image frequency cancelling mixer stage for use in a quadrature frequency multiplier according to the invention comprises first to fourth mixers, each having a first, respectively a second, input in common with one of the in-phase and phase quadrature signal component receiving terminals of a first, respectively second, quadrature input of the quadrature image frequency cancelling mixer stage, outputs of said first to fourth mixers being pairwise coupled to a summing, respectively a difference stage for selecting a quadrature output signal of a wanted frequency and rejecting signals occurring with respect to said wanted frequency at a mirror frequency.

By properly combining the in-phase and phase quadrature components of the above quadrature signal having a frequency at either the sum or the difference value of the signal input frequencies of said arbitrary pair of quadrature signals, a quadrature signal of a wanted frequency is being selected, whereas signals occurring at a frequency mirrored with respect to the wanted frequency are being rejected.

For instance, to triple the frequency f1 of a quadrature signal, the quadrature image frequency cancelling mixer stage is provided through its first and second quadrature inputs with a quadrature input signal I1in, Q1in and a quadrature output signal I2out,Q2out with frequency f2 equalizing 2*f1, respectively, of said frequency doubler. The quadrature image frequency cancelling mixer stage provides a quadrature output signal I3out,Q3out of a frequency f3, which corresponds to the summation of the frequencies f1 and f2 of the input signals at its first and second quadrature inputs, respectively, and cancelling signals of a frequency f1', which corresponds to the difference between the frequencies f2 and f1 of said input signals.

To further widen the choice of frequencies, which can be obtained, the quadrature frequency multiplier according to the invention is preferably characterised by the quadrature signal path being supplied with a quadrature signal of an input frequency and including said frequency doubler being part of an array of first to m cascade connected corresponding frequency doublers, the first quadrature input of said quadrature image frequency cancelling mixer stage being coupled to a quadrature input of the i^{th} frequency doubler and the second quadrature input of said quadrature image frequency cancelling mixer stage being coupled to a quadrature outputs of the j^{th} frequency doubler within said array of first to m cascade connected corresponding frequency doublers, with i and j varying between 1 and m.

By an appropriate arrangement of frequency doublers and quadrature image frequency cancelling mixer stages, quadrature signals at any frequency of n*fin, with n being a natural or positiv integer, can be derived from an input frequency fin. Such arrangement is preferably characterised by said quadrature image frequency cancelling mixer stage having a quadrature output being connected to a first quadrature input of a further quadrature image frequency cancelling mixer stage. This allows for a simultaneous derivation of n quadrature output signals at mutually equidistant frequencies n*fin.

To reduce crosstalk from input to output caused e.g. by leakage of the in-phase and phase quadrature input signals Iin and Qin to the in-phase and phase quadrature phase quadrature output terminals of the quadrature frequency multiplier due to spurious response or unwanted DC offset, a resonance amplifier is preferably being coupled to the in-phase and phase quadrature phase quadrature output terminals of said frequency doubler for a pass band selection of said quadrature output signal Iout,Qout.

The invention also relates to a receiver comprising an FM demodulator providing a baseband modulation signal comprising a stereo multiplex signal including a 19 kHz stereo pilot, an RDS signal modulated on an 57 kHz RDS carrier signal and an audio signal modulated on an 76 kHz carrier signal, being supplied to a stereo decoder, an RDS decoder and an audio signal demodulator and comprising a local oscillator generating a pilot controlled 19 kHz local carrier signal.

According to an aspect of the invention, said receiver is characterised by a quadrature frequency multiplier being coupled to said local oscillator and providing demodulation carrier signals of twice, three and four times said 19 kHz local carrier signal to said stereodecoder, an RDS decoder and an audio signal demodulator, respectively.

According to another aspect of the invention the method of quadrature frequency doubling to be applied in the quadrature frequency multiplier is based on a goniometric principle using simple mathematical signal operations, like multiplication and summation, allowing for a more simple and robust circuit implementation than the abovementioned known quadrature frequency doubler. By applying the invention the accuracy in the 90° phase difference between the in-phase and phase quadrature components of the quadrature input signal Iin,Qin is not affected, making the circuit suitable for multiple cascaded application.

These and further aspects and advantages of the invention will be discussed more in detail hereinafter with reference to the disclosure of preferred embodiments, and in particular with reference to the appended Figures, wherein:
Figure 1 shows an embodiment of a quadrature frequency multiplier according to the invention;
Figure 2 shows an embodiment of receiver according to the invention including frequency multiplying means deriving a plurality of pilot controlled local demodulation carriers for synchronous quadrature demodulation of various signals within a single baseband modulation signal;
Figure 3 shows a frequency spectrum of a baseband FM multiplex signal comprising a stereomultiplex signal, an RDS signal and an audio signal;
Figure 4 shows an embodiment of a single quadrature frequency doubler for use in a quadrature frequency multiplier according to the invention.

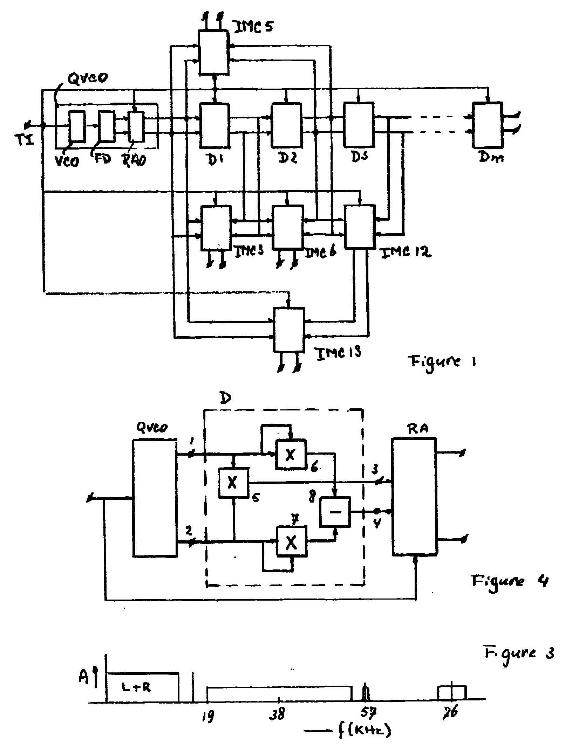

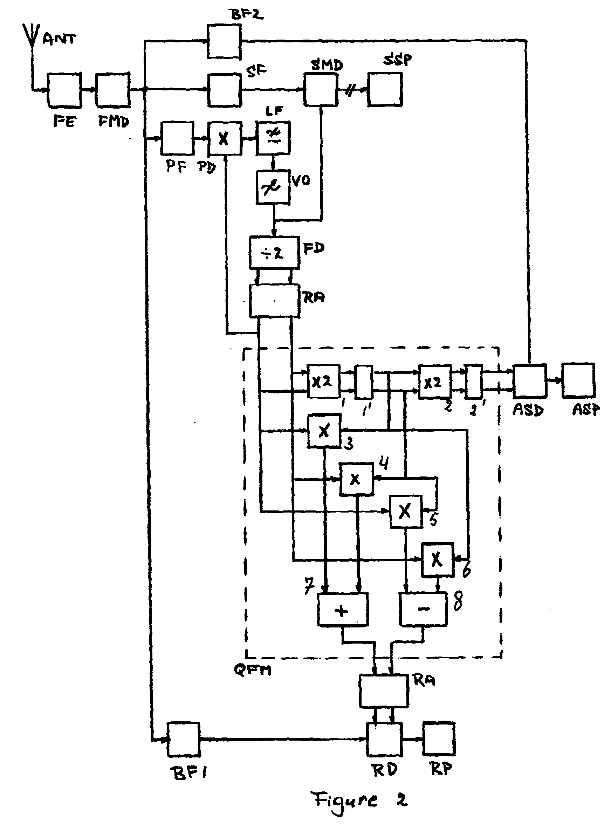

Figure 1 shows an embodiment of a quadrature frequency multiplier according to the invention comprising an array of cascaded, mutually corresponding, selective quadrature frequency doublers D1-Dm, each including a frequency doubler followed by a resonance amplifier, as shown by way of example in Figure 4 as well as an arrangement of selective first to fifth quadrature image frequency cancelling mixer stages IMC3, IMC5, IMC6, IMC12and IMC13, each including a quadrature image frequency cancelling mixer stage such as shown in Figure 2 followed by a resonance amplifier. The resonance amplifiers selectively amplify the quadrature signals applied thereto, therewith reducing spurious response due to DC offset and/or signal leakage and also improve the mutual matching of the in-phase and phase quadrature components of these quadrature signals, however, they are not essential in the functioning of the quadrature frequency multiplier according to the invention. In the following description of this Figure 1, frequency doublers and quadrature image frequency cancelling mixer stages are understood to include a resonance amplifier.

The frequency doublers D1-Dm are included in a quadrature signal path QSP, the resonance amplifiers thereof being controlled in frequency by a tuning control signal ft. The array is preceded by a tuneable quadrature oscillator QVCO comprising a voltage controlled oscillator VCO followed by a phase splitting divide-by-two frequency divider FD and subsequent resonance amplifier RA0. The voltage controlled oscillator VCO generates an oscillator signal at a frequency 2*fin, whereas the phase splitting divide-by-two frequency divider FD provides a conversion of said oscillator signal into in-phase and phase quadrature components of a pair of phase quadrature signals, in short also being indicated as a quadrature signal, of a frequency fin, hereinafter also being indicated as input frequency. Said pair of phase quadrature signals is selectively amplified in the resonance amplifier RA0.

The quadrature output signal of the tuneable quadrature oscillator QVCO is being supplied as a pair of phase quadrature input signals with in-phase and phase quadrature components Iin, Qin to the first frequency doubler, i.e. the frequency doubler D1, in the quadrature signal path QSP, and simultaneously to first in-phase and phase quadrature inputs, hereinafter also indicated as first quadrature input, of first and second quadrature image frequency cancelling mixer stage IMC3, respectively IM5. The frequency doubler D1 derives from said quadrature input signal Iin, Qin a quadrature signal at a frequency of 2*fin, i.e. at double frequency of said quadrature input signal Iin, Qin. This 2*fin quadrature signal is being supplied to the second frequency doubler in the array, i.e. the frequency doubler D2 and simultaneously to a second quadrature input of the first quadrature image frequency cancelling mixer stage IMC3 as well as to a first quadrature input of a third quadrature image frequency cancelling mixer stage IMC6.

The second frequency doubler D2 derives from the lastmentioned 2*fin quadrature signal a quadrature signal at a frequency of 4*fin, i.e. at fourfold frequency fin of said quadrature input signal Iin, Qin. This 4*fin quadrature signal is being supplied to the third frequency doubler in the array, i.e. the frequency doubler D3 and simultaneously to a second quadrature input of the second quadrature image frequency cancelling mixer stage IMC5, to a second quadrature input of the third quadrature image frequency cancelling mixer stage IMC6 and to a first quadrature input of a fourth quadrature image frequency cancelling mixer stage IMC12.

The third frequency doubler D3 derives from the lastmentioned 4*fin quadrature signal a quadrature signal at a frequency of 8*fin, i.e. at eight times the frequency fin of the quadrature input signal Iin, Qin. This 8*fin quadrature signal is being supplied subsequently through the fourth, fifth, ... frequency doubler in the array (not shown) to the last frequency doubler in the array, i.e. frequency doubler Dm, and simultaneously to a second quadrature input of the second quadrature image frequency cancelling mixer stage IMC5 as well as to a second quadrature input of the fourth quadrature image frequency cancelling mixer stage IMC12.

A quadrature signal output of the fourth quadrature image frequency cancelling mixer stage IMC12 is coupled to a second quadrature input of a fifth quadrature image frequency cancelling mixer stage IMC13. A first quadrature input of this fifth quadrature image frequency cancelling mixer stage IMC13 is being provided with the above quadrature input signal Iin, Qin of frequency fin.

The above tuning control signal ft is supplied to a tuning input TI of the voltage controlled oscillator VCO as well as to tuning inputs of the resonance amplifier RA0, the resonance amplifiers of D1-Dm and the resonance amplifiers of the first to fifth quadrature image frequency cancelling mixer stages IMC3, IMC5, IMC6, IMC12and IMC13 for a control of the frequency of the voltage controlled oscillator VCO and for frequency tracking of said resonance amplifiers.

Where the frequency doublers D1-Dm provide frequency multiplication of the input frequency with a factor 2^{j}, in which j varies from 1 to m, the first quadrature image frequency cancelling mixer stage IMC3 provide a quadrature signal at the sum frequency fin+2*fin, i.e. at 3*fin. The second quadrature image frequency cancelling mixer stage IMC5 provide a quadrature signal at the sum frequency fin+4*fin, i.e. at 5*fin. The third quadrature image frequency cancelling mixer stage IMC6 provide a quadrature signal at the sum frequency 2*fin+4*fin, i.e. at 6*fin. The fourth quadrature image frequency cancelling mixer stage IMC12 provide a quadrature signal at the sum frequency 4*fin+8*fin, i.e. at 12*fin. The fifth quadrature image frequency cancelling mixer stage IMC13 provide a quadrature signal at the sum frequency fin+12*fin, i.e. at 13*fin.

A quadrature signal at frequency 6*fin can alternatively be obtained by supplying the 3*fin quadrature output signal of the first quadrature image frequency cancelling mixer stage IMC3 to a frequency doubler (not shown), whereas a quadrature signal at frequency 12*fin can alternatively be obtained by supplying the 6*fin quadrature output signal of the lastmentioned frequency doubler to a subsequent frequency doubler (not shown).

The quadrature image frequency cancelling mixer stages used can be adjusted to select either the sum or the difference frequency of the signals at their first and second inputs by a proper coupling of their first and second inputs to the in-phase and phase quadrature components of the quadrature signal path as will be explained in more detail with reference to Figure 2. It will be clear that with an appriorate arrangement of frequency doublers and quadrature image frequency cancelling mixer stages, quadrature signals at any frequency of n*fin, with n being a natural integer can be obtained.

The invention is not limited to the use of a particular quadrature frequency doubler and/or a particular image quadrature image frequency cancelling mixer stage. In principle known circuitry e.g. such as the frequency doubler as disclosed in US patent number 5,389,886 and/or the image frequency cancelling mixer as disclosed in US patent number 5,140,198 may well be used.

Figure 2 shows an FM receiver according to the invention comprising a front end FE receiving a wanted FM RF input signal from antenna means ANT and converting the same into an FM IF (intermediate frequency) signal, which is supplied to a frequency demodulator FMD. The frequency demodulator FMD demodulates said FM IF signal into a baseband modulation signal as shown in Figure 3. The baseband modulation signal comprises three signal components, to wit a stereomultiplex signal including a baseband stereo sum signal (L+R) within a 15 KHz baseband frequency range, a stereo difference signal (L-R) being double sideband modulated on a suppressed 38 kHz carrier extending within a frequency range from 23 to 53 KHz and a 19 kHz stereo pilot, an RDS signal modulated on an 57 kHz RDS carrier and an audio signal modulated on an 76 kHz carrier. The stereomultiplex signal is selected in stereomultiplex filter SF and supplied to a synchronous stereodecoder SMD to provide a stereo left and stereo right baseband signals to stereo signal processor SP for further processing and reproduction. The modulated RDS signal is selected in an RDS band pass filter BF1 and supplied to a synchronous quadrature RDS decoder RD to provide the baseband RDS signal, which is further processed and displayed in RDS signal processing and display means RP. The modulated audio signal is selected in audio signal filter BF2 and supplied to a synchronous quadrature audio signal demodulator ASD to provide the baseband audiosignal to an audio signal processor ASP for further processing and reproduction. The demodulation carriers needed for the synchronous demodulation of said three signal components are derived from a pilot controlled local 19KHz oscillator signal. To obtain said 19KHz oscillatorsignal a PLL (phase locked loop) is used, a phase detector PD thereof receiving at a first input said 19 kHz stereo pilot from the frequency demodulator FMD through a pilot filter PF. An output ofthe phase detector PD is coupled through a loop filter LF to a control input of said voltage controlled oscillator VO. The voltage controlled oscillator VO generates an oscillator signal of a frequency of 38 KHz, which is supplied to a quadrature phase splitting divide-by-two frequency divider FD providing in-phase and phase quadrature components of a pair of phase quadrature oscillator signals input signals Ip and Qp of a frequency equal to 19 kHz stereo pilot, as well as to a demodulation carrier input of the synchronous stereodecoder SMD. The in-phase component Ip of the pair of phase quadrature oscillator signals input signals is fed back to a second input of the phase detector PD therewith obtaining accurate phase coupling of the output signals of voltage controlled oscillator VO and of the quadrature phase splitting divide-by-two frequency divider FD with the 19 KHz stereo pilot signal.

The receiver described sofar is on itself known and need no further amplification to properly understand the invention. According to the invention, however, the FM receiver as shown in this Figure 2 comprises a quadrature frequency multiplier QFM to generate in-phase and phase quadrature components of quadrature demodulation carriers needed for a synchronous quadrature demodulation of the 57 Khz RDS signal and the 76 Khz audio signal components. The quadrature frequency multiplier FMM therefore includes a cascade arrangement of frequency doublers 1 and 2 subsequently following said quadrature phase splitting divide-by-two frequency divider FD. In the phase locked state of the PLL, these frequency doublers 1 and 2 derive in-phase and phase quadrature components of quadrature signals of respective frequencies of 2*f1, with f1 being 19 KHz, and 4*f1, i.e. of 38KHz and 76 KHz, from the 19 KHz in-phase and phase quadrature components of the quadrature output signal of said quadrature phase splitting divide-by-two frequency divider FD. The 76 KHz pair of phase quadrature signals are being supplied as a pair of synchronous quadrature demodulation carriers to the synchronous quadrature audio signal demodulator ASD.

To derive a quadrature signal of a frequency of 57KHz, use is made of a quadrature image frequency cancelling mixer stage 3-8. The image frequency canceller 3-8 comprises two pairs of mixers 3,4 and 5,6, respectively. Mixer 3 receives at its first input the phase quadrature component, e.g. cos ω₁t (in which ω₁ =2πf₁ with f₁ being 19 KHz) of the quadrature output signal of said quadrature phase splitting divide-by-two frequency divider FD and at its second input the in-phase component, sin 2ω₁t, of said quadrature output signal of the frequency doubler 1. Mixer 4 receives at its first input the in-phase component sin ω₁t of the quadrature output signal of said quadrature phase splitting divide-by-two frequency divider FD and at its second input the phase quadrature component cos 2ω₁t of the quadrature output signal of the frequency doubler 1. Mixer 5 receives at its first input the phase quadrature component cos ω₁t of the quadrature output signal of said quadrature phase splitting divide-by-two frequency divider FD and at its second input the phase quadrature component cos 2ω₁t of the quadrature output signal of the frequency doubler 1. Mixer 6 receives at its first input the in-phase component sin ω₁t of the quadrature output signal of said quadrature phase splitting divide-by-two frequency divider FD and at its second input the in-phase component sin 2ω₁t of the quadrature output signals of the frequency doubler 1. The pair of mixers 3,4 are connected to inputs of a summing stage 7 and the pair of mixers 5,6 are connected to inputs of a differential stage 8. Outputs of the summing stage 7 and the differential stage 8 provide the in-phase and phase quadrature components of a quadrature signal of a frequency of 57KHz, equalizing 3*f1, which is supplied as a synchronous quadrature demodulation carrier to the synchronous quadrature RDS decoder RD. The quadrature image cancelling mixer stage 3-8 rejects any signal occurring at the difference frequency f1.

By mutually exchanging the summing stage 7 and the differential stage 8 the quadrature image cancelling mixer stage 3-8 would reverse its operation in that any signal occurring at 3*f1 would be rejected, whereas a quadrature signal of a frequency f1 would be selected.

It will be clear that by using two additional pairs of mixers having their first inputs coupled appropriately to the in-phase and phase quadrature terminals of the quadrature output of the divide-by-two frequency divider FD and their second inputs to the in-phase and phase quadrature terminals quadrature outputs of the frequency doubler 20, a quadrature signal of frequency 5*f1 can be obtained, and so forth and so on.

Figure 4 shows an embodiment of a quadrature frequency doubler D according to the invention having a quadrature input with in-phase and phase quadrature terminals 1, 2, receiving in-phase and phase quadrature components of a quadrature input signals Iin,Qin, e.g. sin ω₁t and cos ω₁t, from a quadrature tuneable oscillator QVCO and providing at in-phase and phase quadrature terminals of a quadrature output 3, 4, in-phase and phase quadrature components of a quadrature output signal Iout,Qout, respectively. The quadrature frequency doubler D comprises a multiplier circuit 5 being coupled through a pair of inputs to the quadrature inputs 1, 2 for mutually multiplying the in-phase and phase quadrature components of the quadrature input signal Iin,Qin into sin ω₁t*cos ω₁t, which in frequency equalizes to sin 2*ω₁t, therewith obtaining the in-phase component lout of said quadrature output signal Iout,Qout. The in-phase and phase quadrature terminals 1, 2 of the quadrature input 1, 2 are respectively coupled to first and second squaring circuits 6 and 7, which provide the square value of the in-phase and phase quadrature components of the quadrature input signals Iin,Qin, i.e. sin²ω₁t and cos²ω₁t, at their respective outputs. The outputs of the first and second squaring circuits 6 and 7 are being coupled to first and second input terminals of a differential circuit 8 to form the difference between the square value of the the in-phase and phase quadrature components of the quadrature input signals Iin,Qin, i.e. sin²ω₁t - cos²ω₁t. This difference signal cos²ω₁t equalizes in frequency to cos 2*ω₁t, which constitutes the phase quadrature component Qout of said quadrature output signal lout and Qout of said frequency doubler D. The quadrature output of the frequency doubler D is coupled to a quadrature input of a tuneable quadrature resonance amplifier RA for a selective amplification of the quadrature output signal of the frequency doubler D. To attune said quadrature tuneable oscillator QVCO at a wanted frequency, a tuning control signal is supplied to a tuning input thereof, which tuning control signal is simultaneously supplied to a tuning control input of said tuneable quadrature resonance amplifier RA to provide frequency tracking thereof.

The invention is embodied in each new characteristic and each combination of characteristics. Any reference signs do not limit the scope of the claims. The word "comprising" does not exclude the presence of other elements than those listed in a claim. Use of the word "a" or "an" preceding an element does not exclude the presence of a plurality of such elements.

## Claims

1. Quadrature frequency multiplier comprising a frequency doubler included in a quadrature signal path, said frequency doubler receiving a quadrature input signal and providing a quadrature output signal of a frequency, which is double that of said input signal, **characterised by** a quadrature image frequency cancelling mixer stage, having first and second quadrature inputs coupled to said quadrature signal path across said frequency doubler and providing a quadrature signal at a quadrature output having a frequency corresponding to the sum or difference of the frequencies of the signals at said first and second quadrature inputs and differing from the frequencies of the signals occurring in said quadrature signal path.

2. Quadrature frequency multiplier according to claim 1, **characterised by** the quadrature signal path being supplied with a quadrature signal of an input frequency and including said frequency doubler being part of an array of first to m cascade connected corresponding frequency doublers, the first quadrature input of said quadrature image frequency cancelling mixer stage being coupled to a quadrature input of the i^{th} frequency doubler and the second quadrature input of said quadrature image frequency cancelling mixer stage being coupled to a quadrature outputs of the j^{th} frequency doubler within said array of first to m cascade connected corresponding frequency doublers, with i and j varying between 1 and m.

3. Quadrature frequency multiplier according to claim 1 or 2, **characterised by** said quadrature image frequency cancelling mixer stage having a quadrature output being connected to a first quadrature input of a further quadrature image frequency cancelling mixer stage.

4. Quadrature frequency multiplier according to one of claims 1 to 3, **characterised by** said quadrature image frequency cancelling mixer stage supplying a quadrature signal to a quadrature input of a frequency doubler providing a quadrature output signal of a frequency, which is double that of said quadrature signal.

5. Quadrature frequency multiplier according to one of claims 1 to 4, **characterised by** first to fourth mixers, each having a first, respectively a second, input in common with one of the in-phase and phase quadrature signal component receiving terminals of a first, respectively second, quadrature input of the quadrature image frequency cancelling mixer stage, outputs of said first to fourth mixers being pairwise coupled to a summing, respectively a difference stage for selecting a quadrature output signal of a wanted frequency and rejecting signals occurring with respect to said wanted frequency at a mirror frequency.

6. Quadrature frequency multiplier according to claim one of claims 1 to 5, **characterised by** said frequency doubler and said quadrature image frequency cancelling mixer stage being coupled to a resonance amplifier for a pass band selection of the output signal thereof.

7. Receiver comprising an FM demodulator providing a baseband modulation signal comprising a stereo multiplex signal including a 19 kHz stereo pilot, an RDS signal modulated on an 57 kHz RDS carrier signal and an audio signal modulated on an 76 kHz carrier signal, being supplied to a stereo decoder, an RDS decoder and an audio signal demodulator and comprising a local oscillator generating a pilot controlled 19 kHz local carrier signal **characterised by** quadrature frequency multiplier according to one of claims 4 being coupled to said local oscillator and providing demodulation carrier signals of twice, three and four times said 19 kHz local carrier signal to said stereodecoder, an RDS decoder and an audio signal demodulator, respectively.

8. Frequency doubler for use in quadrature frequency multiplier according to one of claims 1 to 6, **characterised by** a multiplier circuit receiving in-phase and phase quadrature components of a quadrature input signal for mutually multiplying these components, and for providing one of the in-phase and phase quadrature components of a quadrature output signal, said in-phase and phase quadrature components of the quadrature input signal being supplied to a pair of first and second squaring circuits, respectively, outputs thereof being coupled to first and second input terminals of a differential circuit providing the other of said in-phase and phase quadrature components of the quadrature output signal.
